# EUROPEAN PATENT APPLICATION

(11) **EP 2 752 501 A1**
(43) Date of publication of application: **09.07.2014**
(21) Application number: 11871690.1
(22) Date of filing: 30.08.2011
(51) Int. Cl.: C23C 14/34, C23C 14/35, H05H 1/46

(54) **SPUTTERING THIN FILM FORMING APPARATUS**

(71) Applicant: EMD Corporation, Shiga 520-2323 (JP)
(72) Inventor: SETSUHARA, Yuichi, Suita-shi Osaka 565-0871 (JP); EBE, Akinori, Shiga 520-2323 (JP)
(74) Representative: Ludewigt, Christoph
(86) International application number: PCT/JP2011/069622
(87) International publication number: WO 2013/030954

(57) **Abstract**

A thin-film formation sputtering device capable of forming a high-quality thin film at high rates is provided. A sputtering device 10 includes a target holder 14 provided in a vacuum container 11, a substrate holder 15 facing the target holder 14, a means 19 for introducing a plasma generation gas into the vacuum container 11, a means 161 for generating an electric field for sputtering in a region including a surface of a target T, an antenna placement room 182 provided between inner and outer surfaces of a wall of the vacuum container as well as separated from an inner space of the vacuum container by a dielectric window 183, and a radio-frequency antenna 13, which is provided in the antenna placement room 182, for generating a radio-frequency induction electric field in the region including the surface of the target held by the target holder.

## Description

### TECHNICAL FIELD

The present invention relates to a thin-film formation sputtering device for forming a predetermined thin film on the surface of a substrate by sputtering a target using plasma.

### BACKGROUND ART

Parallel-plate type thin-film formation sputtering devices, in which a metallic sputtering target (cathode) and a substrate are arranged so as to face each other in a vacuum container, have been widely used. In this device, an inert gas (e.g. argon gas) is introduced into the vacuum container, and a direct-current voltage or radio-frequency voltage is applied to the target to generate an electric field perpendicular to the surface of the target and thereby generate discharge plasma in the vicinity of the target. Due to the action of the ions in the generated plasma, the target is sputtered and an objective thin film is formed on the surface of the substrate.

The parallel-plate type thin-film formation sputtering device has the problem that the sputtering rate cannot be adequately increased. If the electric field perpendicular to the target surface is strengthened, the sputtering rate will increase and a certain amount of increase in the deposition rate will be achieved. However, the operation also has the adverse effect that the high-energy ions rebound after colliding with the target and impinge on the substrate, incurring a considerable amount of damage to the substrate (plasma damage).

A magnetron thin-film formation sputtering device is one example of the thin-film formation sputtering devices that enable high-speed film deposition. In the magnetron thin-film formation sputtering device, a magnetic field parallel to the surface of a target is generated in a region in the vicinity of the target surface by means of an electromagnet or permanent magnet provided behind the target, and simultaneously, an electric field perpendicular to the same surface is generated by applying a direct-current voltage or radio-frequency voltage to the target. These magnetic field and electric field generate plasma which is localized in the vicinity of the target surface. The increased plasma density in that region causes more positive ions to fly from the plasma onto the target, whereby the target is efficiently sputtered. As compared with a device which uses no magnetic field, the magnetron thin-film formation sputtering device is advantageous, for example, in that the deposition rate is higher as well as in that the localization of the plasma in the vicinity of the target decreases the temperature rise of the substrate and helps to suppress damage to the substrate.

However, even the magnetron thin-film formation sputtering device cannot achieve an adequately high deposition rate as compared with plasma CVD devices and the like.

Furthermore, in a reactive sputtering that is performed when an oxide thin film is to be formed, the electric field on the target surface becomes weakened due to the charge build-up of the target surface caused by a coating of oxide produced by the reaction of the target surface with oxygen. Consequently, the plasma density decreases, causing a significant decrease in the deposition rate on the substrate. Thus, with the conventional parallel-plate type thin-film formation sputtering device or magnetron thin-film formation sputtering device, it is difficult to form an oxide thin film at high rates.

Patent Document 1 discloses a thin-film formation sputtering device that has the configuration of the aforementioned magnetron thin-film formation sputtering device with a radio-frequency coil additionally provided between the target and the substrate in the film deposition chamber. Patent Document 2 discloses a magnetron thin-film formation sputtering device in which a radio-frequency coil is provided outside the film deposition chamber. In these devices, a radio-frequency induction electric field is generated in the vicinity of the target surface by the radio-frequency coil in addition to the magnetic field and electric field similar to those generated in a normal magnetron sputtering device. The added electric field increases the amount of ions which sputter the target, whereby a higher deposition rate is achieved. In the case of forming a thin film of oxide, nitride or a similar compound, the increase in the amount of target-sputtering ions also has the effect of immediately sputtering off the reaction product (e.g. oxide or nitride) from the target surface, thus preventing this surface from being coated with the compound. Thus, the deposition rate in the reactive sputtering is also prevented from decreasing.

### BACKGROUND ART DOCUMENT

### PATENT DOCUMENT

Patent Document 1: JP-A 2000-273629 (Paragraphs [0007]-[0009], Figs. 2 and 4)
Patent Document 2: JP-A 2002-513862 (Paragraphs [0020], [0021] and [0028] as well as Figs. 2 and 5)

### SUMMARY OF THE INVENTION

### PROBLEM TO BE SOLVED BY THE INVENTION

In the thin-film formation sputtering device disclosed in Patent Document 1, since the radio-frequency coil is located inside the film deposition chamber, the radio-frequency coil is also exposed to the plasma and undergoes sputtering. Consequently, the material of the radio-frequency coil may possibly be mixed in the thin film as an impurity and deteriorate the quality of the thin film. Another problem is that arranging the radio-frequency coil between the substrate and the target inevitably makes the distance between the target and the substrate greater than in the case where no such radio-frequency coil is present. As a result, particles of the target become more diffused and the number of target particles reaching the substance decreases, so that the deposition rate becomes lower.

In the case of the thin-film formation sputtering device disclosed in Patent Document 2, since the radio-frequency coil is located outside the film deposition chamber, the problem of the sputtering of the radio-frequency coil or the diffusion of the target particles does not occur. However, the radio-frequency induction electric field generated in the film deposition chamber is weaker than in the case where the radio-frequency coil is provided inside the film deposition chamber.

The problem to be solved by the present invention is to provide a thin-film formation sputtering device capable of forming a high-quality thin film at high rates.

### MEANS FOR SOLVING THE PROBLEM

The thin-film formation sputtering device according to the present invention aimed at solving the previously described problem includes:
a) a vacuum container;
b) a target holder provided in the vacuum container;
c) a substrate holder facing the target holder;
d) a plasma generation gas introduction section for introducing a plasma generation gas into the vacuum container;
e) an electric field generator for generating a sputtering direct-current electric field or radio-frequency electric field in a region including a surface of a target to be held by the target holder;
f) an antenna placement section provided between the inner and outer surfaces of a wall of the vacuum container as well as separated from the inner space of the vacuum container by a partition member made of a dielectric material; and
g) a radio-frequency antenna, provided in the antenna placement section, for generating a radio-frequency induction electric field in the region including the surface of the target held by the target holder.

In the thin-film formation sputtering device according to the present invention, a cloud of plasma that originates from the molecules of an ionized plasma generation gas is generated in a region near the surface of the target due to the effect of the electric field generated by the electric field generator. The plasma in the vicinity of the surface of the target can be maintained at high densities by generating additional plasma by the radio-frequency antenna in a region including the target surface and superposing this plasma on the sputter electric discharge in the vicinity of the target surface. Thus, the sputtering can be performed at higher rates. In the case of a reactive-sputtering film deposition process, even if an oxide, nitride or similar reaction product adheres to the target surface, the product can be removed since the plasma in the vicinity of the target surface can be maintained at high densities by the additional plasma generated by the radio-frequency antenna. Thus, the aforementioned product is prevented from covering the surface of the target and decreasing the deposition rate.

Since the radio-frequency antenna placement section is separated from the inner space of the vacuum container by the partition member made of a dielectric material, the radio-frequency antenna will not be exposed to the plasma in the vacuum container and sputtered. Therefore, the material of the radio-frequency antenna cannot be mixed in the thin-film formed on the substrate.

Since the radio-frequency antenna is arranged within the radio-frequency antenna section located between the inner and outer surfaces of a wall of the vacuum container, a stronger radio-frequency induction electric field can be generated in the vacuum container than in the case where the radio-frequency antenna is provided outside the vacuum container, and furthermore, the distance between the target holder and the substrate holder can be reduced. Accordingly, a higher deposition rate can be achieved.

The thin-film formation sputtering device according to the present invention may preferably include a magnetic field generator for generating, in the region including the surface of the target, a magnetic field having a component orthogonal to the direct-current electric field or the radio-frequency electric field. The magnetic field generated by the magnetic field generator causes the plasma generated by the electric field generator and the radio-frequency antenna to be localized in the vicinity of the target surface, making the plasma density even higher, so that the target will be more efficiently sputtered. The present invention can also be applied in a thin-film formation sputtering device with no magnetic field generator, such as a bipolar sputtering device in which the substrate holder and the target holder are used as two electrodes for the electric field generator.

The thin-film formation sputtering device according to the present invention may include a substrate-activating radio-frequency antenna for generating a radio-frequency induction electric field in the region including the surface of the substrate held by the substrate holder. This electric field activates the surface of the substrate and promotes reactions involved in the thin-film formation process on the substrate surface. Although the substrate-activating radio-frequency antenna may be provided inside the vacuum container, it is preferable to arrange it in a substrate-activating radio-frequency antenna placement section provided between the inner and outer surfaces of a wall of the vacuum container, for the same reason as previously described in relation to the radio-frequency antenna for generating a radio-frequency induction electric field in the vicinity of the target.

In one preferable mode of the thin-film formation sputtering device according to the present invention:
the portion of the wall of the vacuum container in which the antenna placement section is provided is in the form of a projecting section protruding into the inner space of the vacuum container;
at least a portion of the lateral side of the projecting section, including the tip of the lateral side, is made of a dielectric material; and
the target holder is provided lateral to the projecting section.

In this structure, the dielectric portion of the projecting section does not block the radio-frequency induction electric field generated by the radio-frequency antenna, so that the radio-frequency induction electric field can be efficiently generated in a region near the surface of the target held by the target holder.

### EFFECT OF THE INVENTION

In the thin-film formation sputtering device according to the present invention, since the radio-frequency antenna is arranged in the radio-frequency antenna placement section provided between the inner and outer surfaces of the vacuum container, a strong radio-frequency induction electric field is generated in a region including the surface of the target, whereby the plasma density is increased and a high deposition rate is achieved. The radio-frequency antenna is separated from the inner space of the vacuum container by a partition member made of a dielectric material and hence will not be sputtered by the plasma. Thus, the material of the radio-frequency antenna is prevented from being mixed in the thin film, so that a high-quality thin film can be formed.

### BRIEF DESCRIPTION OF THE DRAWINGS

Fig. 1 is a vertical sectional view of a first embodiment of the thin-film formation sputtering device according to the present invention.
Fig. 2 is a side view of one example of the radio-frequency antenna.
Fig. 3 is a bottom view of the vacuum container in a second embodiment of the thin-film formation sputtering device according to the present invention.
Fig. 4 is a bottom view of the vacuum container in one variation of the thin-film formation sputtering device of the second embodiment.
Fig. 5 is a vertical sectional view of a third embodiment of the thin-film formation sputtering device according to the present invention.
Fig. 6 is a vertical sectional view of a fourth embodiment of the thin-film formation sputtering device according to the present invention.
Fig. 7 is a vertical sectional view of one variation of the thin-film formation sputtering device of the fourth embodiment.
Fig. 8 is a vertical sectional view of a fifth embodiment of the thin-film formation sputtering device according to the present invention.
Fig. 9A is a vertical sectional view of a sixth embodiment of the thin-film formation sputtering device according to the present invention, and Fig. 9B a partially enlarged view of the same device.
Fig. 10A is a vertical sectional view of one variation of the radio-frequency antenna, and Fig. 10B is a top view showing the main portion of the same antenna.

### MODE FOR CARRYING OUT THE INVENTION

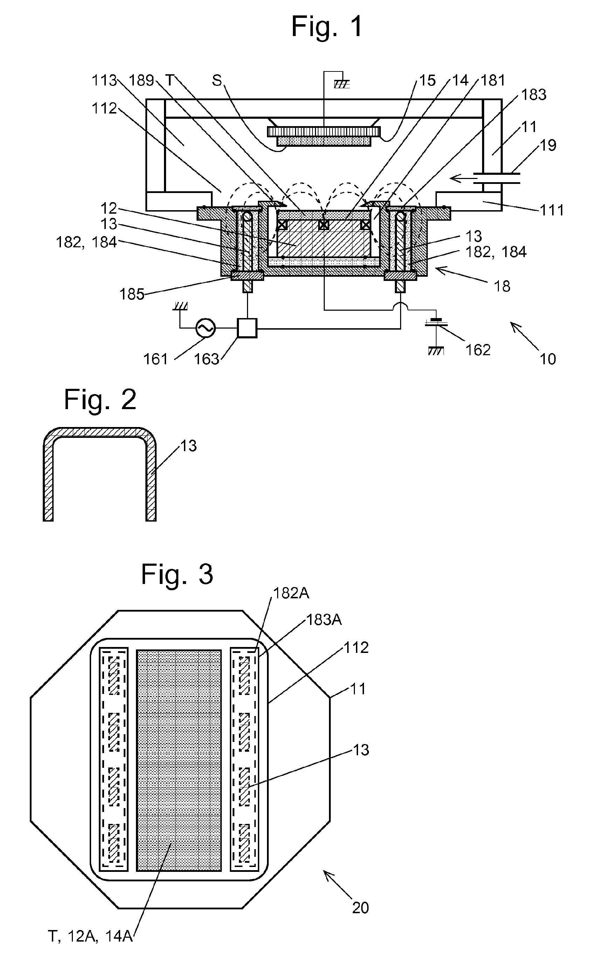

Embodiments of the thin-film formation sputtering device according to the present invention are hereinafter described by means of Figs. 1-10B.

### FIRST EMBODIMENT

A thin-film formation sputtering device 10 according to the first embodiment is hereinafter described by means of Figs. 1 and 2. The thin-film formation sputtering device 10 is designed for forming a predetermined thin film on the surface of a substrate S by sputtering a rectangular plate-shaped target T.

The thin-film formation sputtering device 10 has a vacuum container 11 that can be evacuated by a vacuum pump (not shown), a plasma generation gas introduction means 19 for introducing a plasma generation gas into the vacuum container, a magnet 12 for magnetron sputtering which is provided at the bottom of the vacuum container 11 (as will be described later), a radio-frequency antenna 13 which is also provided at the bottom of the vacuum container 11 (as will be described later), a target holder 14 provided on the upper surface of the magnet 12 for magnetron sputtering, and a substrate holder 15 facing the target holder 14. A plate-shaped target T can be attached to the upper surface of the target holder 14, while a substrate S can be attached to the lower surface of the substrate holder 15. The thin-film formation sputtering device 10 is provided with a radio-frequency power source 161 for supplying a radio-frequency power to the radio-frequency antenna 13, and with a direct-current power source 162 for applying a direct-current voltage between the target holder 14 and the substrate holder 15 with the target holder 14 on the positive side. The radio-frequency power source161 is connected to the radio-frequency antenna 13 via an impedance matching box 163.

The vacuum container 11 has a bottom member 111 in which an opening 112 is provided. A target-and-antenna placement section 18 for containing the target holder 14, the magnet 12 for magnetron sputtering and the radio-frequency antenna 13 is attached to the bottom member 111 so as to close the opening 112 from below. A seal material is used to ensure an airtight connection between the target-and-antenna placement section 18 and the bottom member 111 of the vacuum container 11. Accordingly, the wall of the target-and-antenna placement section 18 serves as a portion of the wall of the vacuum container 11. In the target-and-antenna placement section 18, a target placement room (target placement section) 181 is provided directly below the substrate holder 15. Furthermore, a pair of radio-frequency antenna placement rooms 182 are provided inside the wall of the target-and-antenna placement section 18 (i.e. inside the walls of the vacuum container 11) in such positions that the two rooms are located lateral to and on both sides of the target placement room 181.

The target placement room 181 communicates with the inner space 113 of the vacuum container 11 at its upper end. The magnet 12 for magnetron sputtering is mounted in the target placement room 181. The vertical position of the magnet 12 for magnetron sputtering is adjusted so that the upper surface of the target T placed on the target holder 14 (which is provided above the magnet) is at a level close to the upper end of the target-and-antenna placement section 18 (but not necessarily at the same level as this upper end). As a result of arranging the magnet 12 for magnetron sputtering and the target holder 14 in this manner, the target T is positioned within a space that communicates with the inner space 113 of the vacuum container 11.

At the boundary between the upper end of the target placement room 181 and the inner space 113, an eave 189 is formed so as to extend inward from the side wall of the target placement room 181, covering a region near the edges of the four sides of the target T (including those edges) from above.

Inside the radio-frequency antenna placement room 182, the radio-frequency antenna 13 is inserted from below. The radio-frequency antenna 13 is a tubular metallic conductor in the form of a letter "U" (Fig. 2). One such antenna is provided in each of the two radio-frequency antenna placement rooms 182, with the shape of the letter "U" standing upside down. Such a U-shaped radio-frequency antenna corresponds to an inductive coupling antenna whose number of turns is less than one, and its inductance is lower than that of an inductive coupling antenna whose number of turns is equal to or greater than one. The low inductance leads to a low radio-frequency voltage occurring at both ends of the radio-frequency antenna and a suppressed radio-frequency fluctuation of the plasma potential caused by electrostatic coupling to the generated plasma. As a result, an excessive loss of electrons associated with the fluctuation of the plasma potential relative to the ground potential is reduced, and the plasma potential is lowered. This condition enables a thin-film formation process to occur with a low degree of ion damage on the substrate. The pipe of the radio-frequency antenna 13 has the function of cooling the radio-frequency antenna 13 by allowing a coolant (e.g. water) to pass through it when the thin-film formation sputtering device 10 is used. The vertical position of the radio-frequency antenna 13 is adjusted so that the bottom portion of the letter "U" is approximately at the same level as that of the upper surface of the target T (but does not need to be exactly at the same level).

A window made of a dielectric material (dielectric window) 183 is provided between the radio-frequency antenna placement room 182 and the inner space of the vacuum container 11. The space around the radio-frequency antenna 13 within the radio-frequency antenna placement room 182 is filled with a solid dielectric filler 184. Such an arrangement of the radio-frequency antenna 13, the dielectric window 183 and the dielectric filler 184 prevents the radio-frequency antenna 13 from being exposed to the plasma generated in the inner space 113 of the vacuum container 11. However, the dielectric window 183 is directly exposed to the plasma. Therefore, it is preferable to use a highly plasma-resistant material (e.g. quartz) for the dielectric window 183. On the other hand, the dielectric filler 184, which is protected against the plasma by the presence of the dielectric window 183, should preferably be made of a material with high workability rather than high plasma resistance. Examples of highly workable materials include polytetrafluoroethylene (PTFE), polyether ether ketone (PEEK) and other resins. Non-resin materials may also be used as the dielectric filler 184, such as alumina, silica or other ceramic materials.

A cover 185 is attached via a feedthrough to the two legs of the radio-frequency antenna 13 (i.e. the portions corresponding to the two vertical lines of the letter "U"). The cover 185, which is designed to be attached to the lower portion of the radio-frequency antenna placement room 182, has a vacuum seal by which the boundary between the outer space and the area formed by the radio-frequency antenna placement room 182 and the vacuum container 11 can be closed in an airtight manner. The cover 185 can be attached to and detached from the lower portion of the radio-frequency antenna placement room 182, thus enabling the radio-frequency antenna 13 to be easily inserted into or removed from the radio-frequency antenna placement room 182 together with the cover 185.

An operation of the thin-film formation sputtering device 10 according to the first embodiment is hereinafter described.

Initially, a target T and a substrate S are attached to the target holder 14 and the substrate holder 15, respectively. After the vacuum container 11 is evacuated by a vacuum pump, a plasma generation gas is introduced into the vacuum container 11 by the plasma generation gas introduction means 19 so that the pressure in the vacuum container 11 is adjusted at a predetermined level. Subsequently, a direct current is passed through the electromagnet in the magnet 12 for magnetron sputtering to generate, from this magnet 12, a magnetic field in a region in the vicinity of the target T including the conductor of the radio-frequency antenna 13. Simultaneously, a direct-current voltage is applied between the target holder 14 and the substrate holder 15 by energizing the direct-current power source 162, using the two holders as electrodes, to generate a direct-current electric field between the electrodes. Furthermore, a radio-frequency power is supplied from the radio-frequency power source 161 to the radio-frequency antenna 13 to generate a radio-frequency induction electric field around the radio-frequency antenna 13.

Due to the magnetic field, the direct-current electric field and the radio-frequency induction electric field, the molecules of the plasma generation gas are ionized, thus generating plasma. The electrons supplied from the plasma are effectively confined due to an E×B drift in a region where the aforementioned magnetic field orthogonally interests with the aforementioned electric fields, whereby the ionization of the gas molecules is promoted, producing a considerable amount of positive ions. Those positive ions bombard the surface of the target T, causing particles to be sputtered off the surface of the target T. The sputtered particles are transported from the surface of the target T to the substrate S and adhere to the surface of the substrate S. Thus, the sputtered particles deposit on the surface of the substrate S, forming a thin film.

In the thin-film formation sputtering device 10 of the present embodiment, since the radio-frequency antenna 13 is provided in addition to the configuration similar to a conventional magnetron sputtering device (i.e. the magnet 12 for magnetron sputtering and the direct-current power source 162), a cloud of plasma with a higher density can be generated on the surface of the target T than in the case of using only a magnetron sputtering device or a radio-frequency antenna. The high-density plasma promotes the sputtering of the target T and increases the deposition rate.

Since the radio-frequency antenna 13 is contained in the space separated from the inner space 113 of the vacuum container 11 by the dielectric window 183, the radio-frequency antenna 13 will not be exposed to the plasma in the inner space 113 and sputtered. Therefore, the material of the radio-frequency antenna 13 will not be mixed in the thin film formed on the substrate S as an impurity. The spatial separation of the radio-frequency antenna 13 also has the effect of preventing an increase in the temperature of the antenna.

Furthermore, since the radio-frequency antenna 13 is not arranged outside the vacuum container 11 but in the radio-frequency antenna placement room 182 provided inside the wall of the vacuum container 11, the radio-frequency induction electric field generated in the vacuum space 113 can be stronger than in the case where the radio-frequency antenna is arranged outside the vacuum container 11. Another advantage is that the distance between the target holder 14 and the substrate holder 15 can be reduced since there is no need to arrange a radio-frequency antenna or other components between the target holder and the substrate holder. For these reasons, a higher deposition rate can be achieved.

In the present embodiment, since the eave 189 that covers a region near the edges of the four sides of the target T from above is provided, it is possible to sputter only a desired area on the target surface and prevent the sputtering of the target holder or other members that may cause a production of impurities and hence should not be sputtered.

### SECOND EMBODIMENT

A thin-film formation sputtering device 20 according to the second embodiment is hereinafter described by means of Fig. 3. The thin-film formation sputtering device 20 according to the second embodiment is a device for forming a thin film on a rectangular substrate by sputtering a target having a rectangular shape corresponding to the shape of the substrate. In this thin-film formation sputtering device 20, the upper surface of the magnet 12A for magnetron sputtering and the target holder 14A also have rectangular shapes corresponding to the rectangular target. Radio-frequency antenna placement rooms 182A whose shape is elongated along the longer sides of the magnet 12A for magnetron sputtering are provided on both sides of the magnet. A dielectric window 183A has a rectangular shape corresponding to the shape of the radio-frequency antenna placement room 182A. A plurality of radio-frequency antennas 13 are arranged in each of the radio-frequency antenna placement rooms 182A (in the present example, four antennas in each room) along the length of the radio-frequency antenna placement room 182A. All the radio-frequency antennas 13 may be parallel-connected to a radio-frequency power source, or the radio-frequency antennas 13 may be divided into groups, a plurality of antennas included in each group may be parallel-connected to one radio-frequency power source. It is also possible to individually connect each radio-frequency antenna 13 to one radio-frequency power source. Except for the points described thus far, the overall configuration of the thin-film formation sputtering device 20 is the same as that of the thin-film formation sputtering device 10 of the first embodiment.

The operation of the thin-film formation sputtering device 20 is also basically the same as that of the thin-film formation sputtering device 10 of the first embodiment. It should be noted that, in the present embodiment, the same amount of power may be supplied to all the radio-frequency antennas 13 arranged along the length of the radio-frequency antenna placement room 182A, or a different amount of power may be supplied to each of the radio-frequency antennas.

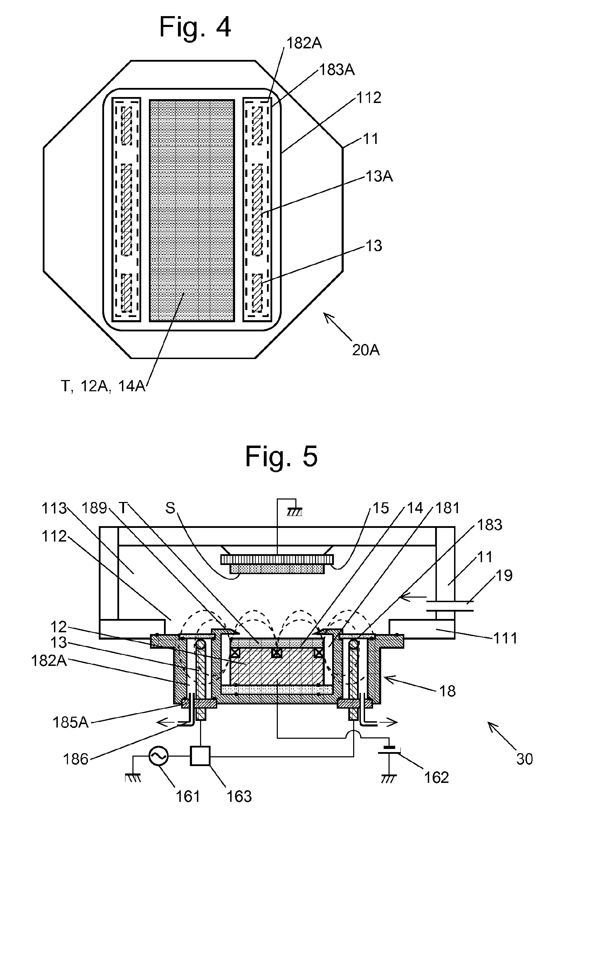

A thin-film formation sputtering device 20A, which is a variation of the second embodiment, is hereinafter described by means of Fig. 4. In the thin-film formation sputtering device 20A, three radio-frequency antennas are arranged in each radio-frequency antenna placement room 182A along the length of this room. As compared with the two radio-frequency antennas arranged at both ends of the three antennas, the central radio-frequency antenna 13A is characterized in that its letter-"U" shape has a longer bottom portion. Except for this point, the thin-film formation sputtering device 20A has the same configuration as that of the thin-film formation sputtering device 20 of the second embodiment. The aim of this variation is as follows: The plasma density generated in a plasma generation device normally has a greater spatial density gradient at a position close to the end (wall) of the vacuum container than at a position close to the center. Accordingly, in the present variation, the conductors of the two radio-frequency antennas 13 located close to the ends of the vacuum container 11 are given a shorter length in the longitudinal direction of the radio-frequency antenna placement room 182A so as to allow for a fine control of the density near the ends of the container, while the conductor of the central radio-frequency antenna 13A is given a longer length since such a fine control is not required in the central region of the vacuum container 11.

### THIRD EMBODIMENT

A thin-film formation sputtering device 30 according to the third embodiment is hereinafter described by means of Fig. 5. In the thin-film formation sputtering device 30 of the present embodiment, an exhaust pipe 186 for evacuating the radio-frequency antenna placement room 182A is provided in a cover 185A in place of the dielectric filler 184 in the thin-film formation sputtering device 10 of the first embodiment. In this device, since the radio-frequency antenna placement room 182A is evacuated in addition to the inner space of the vacuum container 11, a radio-frequency induction electric field can more efficiently be generated in the inner space 113. Furthermore, since there is no pressure difference between the front and back sides of the dielectric window 183, the dielectric window 183 does not need to have high mechanical strength and hence can be made thinner, which further improves the efficiency of supplying the generated radio-frequency induction electric field into the inner space 113. The thin-film formation sputtering device 30 operates in the same manner as that of the thin-film formation sputtering device 10 of the first embodiment.

### FOURTH EMBODIMENT

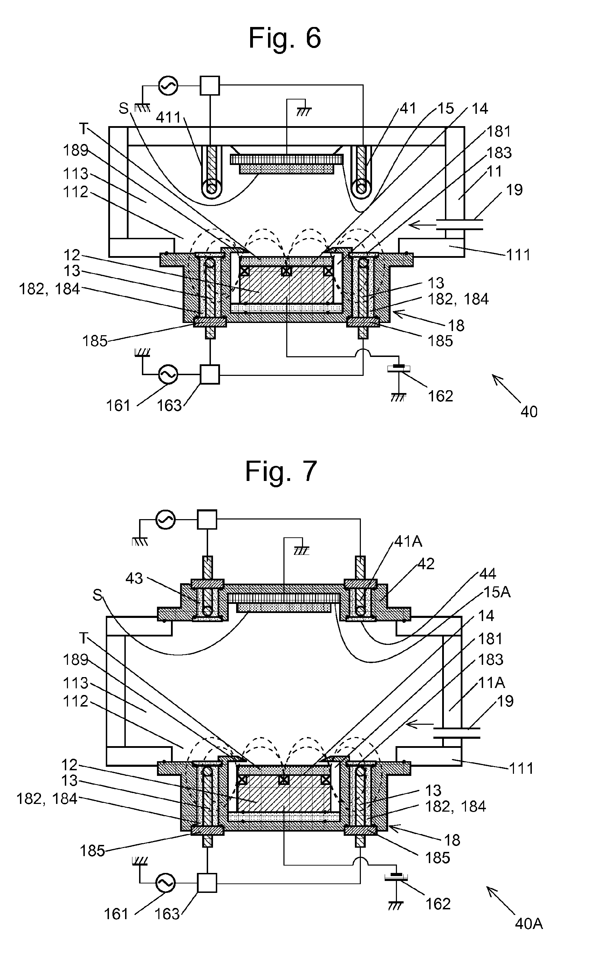

A thin-film formation sputtering device 40 according to the fourth embodiment is hereinafter described by means of Fig. 6. The thin-film formation sputtering device 40 of the present embodiment corresponds to the thin-film formation sputtering device 10 of the first embodiment in which a substrate-activating radio-frequency antenna 41 is additionally provided in the vicinity to the substrate holder 15. The substrate-activating radio-frequency antenna 41 is used for generating a radio-frequency induction electric field in a region near the surface of the substrate S attached to the substrate holder 15 so as to activate atoms on the surface of the substrate S by means of the radio-frequency induction electric field and thereby promote adhesion of the sputtered particles to the surface of the substrate S. Analogous to the radio-frequency antenna 13, the substrate-activating radio-frequency antenna 41 consists of a tubular metallic conductor in the form of the letter "U". A pipe 411 made of a dielectric material for protecting the conductor of the substrate-activating radio-frequency antenna 41 against plasma or sputtered particles is provided around the same conductor. Except for the use of the substrate-activating radio-frequency antenna 41, the configuration and operation of the thin-film formation sputtering device 40 are the same as those of the thin-film formation sputtering device 10 of the first embodiment.

A thin-film formation sputtering device 40A, which is a variation of the fourth embodiment, is hereinafter described by means of Fig. 7. In this embodiment, substrate-activating radio-frequency antennas 41A are provided inside the wall of a vacuum container 11A, analogously to the radio-frequency antennas 13. Specifically, the present thin-film formation sputtering device 40A has the following configuration: An opening is provided in the upper side of the vacuum container 11A, and a substrate-and-antenna placement section 42 is attached so as to close the opening from above in an airtight manner. The substrate-and-antenna placement section 42 has a substrate holder 15A facing the target holder 14, with substrate-activating radio-frequency antenna placement rooms 43 provided on both sides of the substrate holder 15A. A substrate-activating radio-frequency antenna 41A is inserted into the substrate-activating radio-frequency antenna placement room 43 from above, and the space around the substrate-activating radio-frequency antenna 41A is filled with a dielectric filler. A window 44 made of a dielectric material (second dielectric window) is provided between the substrate-activating radio-frequency antenna placement room 43 and the inner space 113 of the vacuum container 11A. The operation of the thin-film formation sputtering device 40A of the present variation is the same as that of the thin-film formation sputtering device 40 of the fourth embodiment.

### FIFTH EMBODIMENT

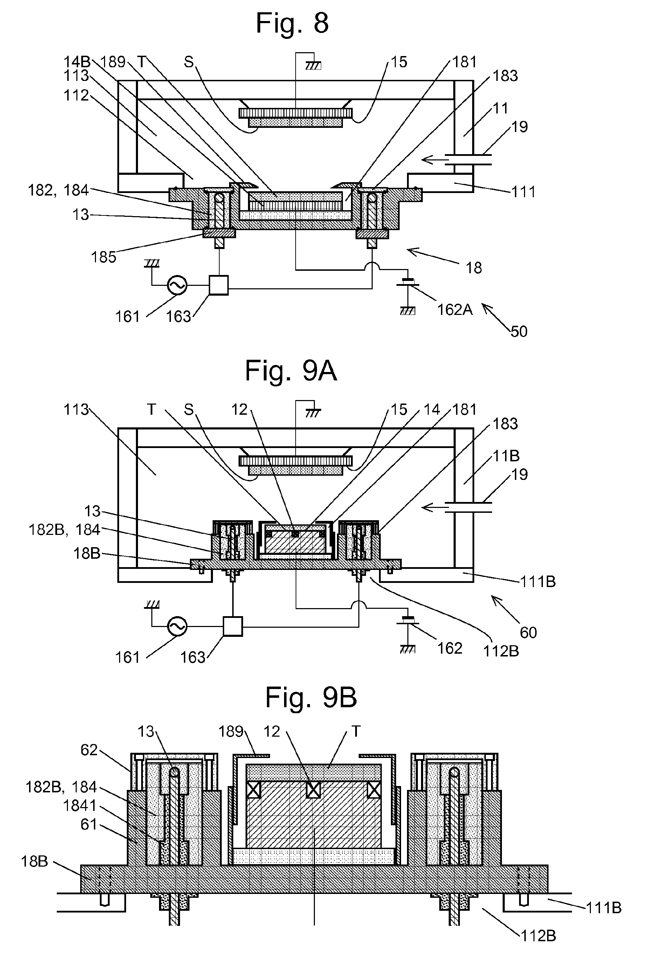

In any of the previously described embodiments, a magnet for magnetron sputtering (magnetic field generator) is used. However, the present invention can be applied in a thin-film formation sputtering device that does not use a magnet for magnetron sputtering. A thin-film formation sputtering device 50 shown in Fig. 8 includes a direct-current power source 162A for applying a voltage between a target holder 14B (which serves as the first electrode) and the substrate holder 15 (which serves as the second electrode) facing the target holder 14B, with the target holder 14B on the negative side. On the other hand, no component corresponding to the magnet 12 for magnetron sputtering is provided in the thin-film formation sputtering device 50. Except for those points, the present device is identical to the thin-film formation sputtering device 10 of the first embodiment. The present thin-film formation sputtering device 50 corresponds to a conventional bipolar sputtering device in which a radio-frequency antenna 13 is additionally provided. Such a bipolar sputtering device can deposit a film at higher rates than those of the conventional one.

### SIXTH EMBODIMENT

A thin-film formation sputtering device 60 according to the sixth embodiment is hereinafter described by means of Figs. 9A and 9B. In the thin-film formation sputtering device 60, an opening 112B is provided in a bottom member 111B of a vacuum container 11B, and a target-and-antenna placement section 18B is provided so as to close the opening 112 from above. The target-and-antenna placement section 18B has two projections 61 protruding from the top of a plate (into an inner space 113B of the vacuum container 11B). A magnet 12 for magnetron sputtering and a target holder 14, which are identical to those used in the first through fourth embodiments, are provided between the two projections 61. An antenna placement section 182B is provided inside each projection 61. A radio-frequency antenna 13, which is identical to those of the first through fifth embodiments, is contained in the antenna placement section 182B. The space around the radio-frequency antenna 13 is filled with a dielectric filler 184. A portion 1841 of the dielectric filler 184 is divided from the other portion. When the radio-frequency antenna 13 is removed from the antenna placement section 182B, the aforementioned portion 1841 is also extracted from the antenna placement section 182B together with the radio-frequency antenna 13. The target-and-antenna placement section 18B is basically made of a metal, except for a portion extending from the tip of the projection 61 (in other words, the upper end, or the end facing the inner space 113B) toward its base (lower end), which consists of a dielectric member 62. The other configuration is the same as the first embodiment.

The dielectric member 62 does not block the radio-frequency induction electric field generated from the radio-frequency antenna 13 contained in the antenna placement section 182B. Therefore, a radio-frequency induction electric field can be efficiently generated in a region near the surface of the target T held on the target holder outside the antenna placement section 182B.

### (Other Embodiments)

The thin-film formation sputtering device according to the preset invention is not limited to the first through sixth embodiments.

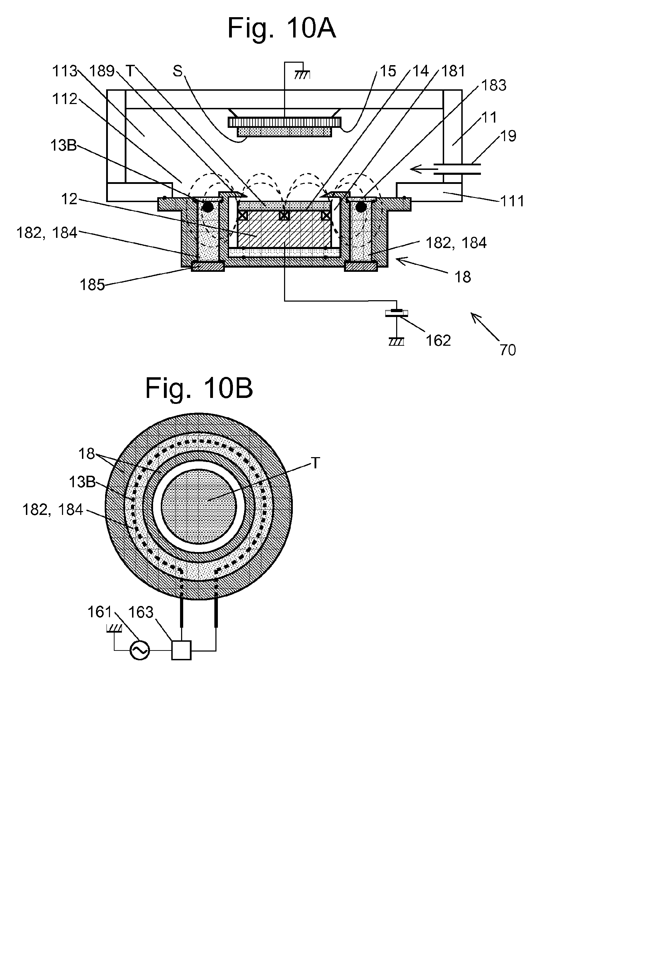

For example, a radio-frequency antenna 13B (Figs. 10A and 10B) that almost completely surrounds the target placement room 181 (but whose number of turns is less than one since it does not completely surround the room) may be used in place of the U-shaped radio-frequency antenna 13.

In the previous embodiments, the antenna placement section (the radio-frequency antenna placement room) in which the radio-frequency antenna is placed is designed as a part disintegrated from the wall of the vacuum container. However, the wall of the vacuum container and the antenna placement section may be formed integrally.

In the previous embodiments, the radio-frequency antenna is prevented from coming in contact with outer atmosphere by putting a dielectric material in the space around the radio-frequency antenna or evacuating the radio-frequency antenna placement room. A device in which the antenna is in contact with the atmosphere also falls within the scope of the present invention, although their contact should preferably be avoided as in the previously described embodiments so as to prevent unnecessary electric discharge.

In place of the direct-current voltage that is applied between the target holder and a ground in the previous embodiments, with the target holder on the negative side, a radio-frequency voltage may be applied between them.

In addition to the plasma generation gas, a reactive gas that can react with the particles of the target and produce a material of the film may be introduced into the vacuum container 11. In particular, when oxygen, nitrogen or a similar reactive gas is mixed in the gas in a conventional reactive-thin-film formation sputtering device, the sputtering rate decreases due to the formation of a compound layer (made of an oxide, nitride or the like) on the surface of the target set on the target holder. By contrast, in the thin-film formation sputtering device of the present embodiment, even if the target surface is covered with a compound layer, a high sputtering rate can be maintained by superposing an inductive coupling plasma on the sputter electric discharge and thereby maintaining a high plasma density in the vicinity of the target surface.

In the previous embodiments, the target placement room and the antenna placement section (room) are provided in the lower portion of the inner space of the vacuum container, while the substrate holder is provided in the upper portion of the inner space. It is also possible to provide the target placement room and the antenna placement section (room) in the lower portion of the vacuum container as well as the substrate holder in the upper portion of the inner space.

### EXPLANATION OF NUMERALS

- 10, 20, 20A, 30, 40, 40A, 50, 60, 70: Thin-Film Formation Sputtering Device
- 11, 11A, 11B: Vacuum Container
- 111, 111B: Bottom Member
- 112, 112B: Opening
- 113, 113B: Inner Space
- 12, 12A: Magnet for Magnetron Sputtering
- 13, 13A, 13B: Radio-Frequency Antenna
- 14, 14A, 14B: Target Holder
- 15, 15A: Substrate Holder
- 161: Radio-Frequency Power Source
- 162, 162A: Direct-Current Power Source
- 163: Impedance Matching Box
- 18, 18B: Target-and-Antenna Placement Section
- 181, 181B: Target Placement Room
- 182, 182A, 182B: Radio-Frequency Antenna Placement Room (Antenna Placement Section)
- 183, 183A: Dielectric Window (Partition Member Made of Dielectric Material)
- 184: Dielectric Filler
- 185, 185A: Cover
- 186: Exhaust Pipe
- 189: Eave
- 19: Plasma Generation Gas Introduction Means
- 41, 41A: Substrate-Activating Radio-Frequency Antenna
- 411: Pipe
- 42: Substrate-and-Antenna Placement Section
- 43: Substrate-Activating Radio-Frequency Antenna Placement Room
- 44: Second Dielectric Window
- 61: Projection
- 62: Dielectric Member

## Claims

1. A thin-film formation sputtering device, comprising:
a) a vacuum container;
b) a target holder provided in the vacuum container;
c) a substrate holder facing the target holder;
d) a plasma generation gas introduction section for introducing a plasma generation gas into the vacuum container;
e) an electric field generator for generating a sputtering direct-current electric field or radio-frequency electric field in a region including a surface of a target to be held by the target holder;
f) an antenna placement section provided between inner and outer surfaces of a wall of the vacuum container as well as separated from an inner space of the vacuum container by a partition member made of a dielectric material; and
g) a radio-frequency antenna, provided in the antenna placement section, for generating a radio-frequency induction electric field in the region including the surface of the target held by the target holder.

2. The thin-film formation sputtering device according to claim 1, further comprising a magnetic field generator for generating, in the region including the surface of the target, a magnetic field having a component orthogonal to the direct-current electric field or the radio-frequency electric field.

3. The thin-film formation sputtering device according to claim 1 or 2, wherein an inside of the antenna placement section is filled with a dielectric filler.

4. The thin-film formation sputtering device according to claim 1 or 2, wherein an inside of the antenna placement section is a vacuum.

5. The thin-film formation sputtering device according to one of claims 1 through 4, wherein a target placement section communicating with the inner space of the vacuum container is provided lateral to the radio-frequency antenna placement section, the target placement section containing the target holder and a target to be held by the target holder.

6. The thin-film formation sputtering device according to one of claims 1 through 5, wherein the radio-frequency antenna is a conductor whose number of turns is less than one.

7. The thin-film formation sputtering device according to claim 6, wherein the radio-frequency antenna is U-shaped.

8. The thin-film formation sputtering device according to one of claims 1 through 7, wherein a plurality of the radio-frequency induction-coupled plasma generators are provided.

9. The thin-film formation sputtering device according to claim 8, wherein intensities of the radio-frequency induction electric fields generated by the radio-frequency induction-coupled plasma generators can be individually set at a different value for each of the radio-frequency induction electric fields.

10. The thin-film formation sputtering device according to one of claims 1 through 9, further comprising a substrate-activating radio-frequency antenna for generating a radio-frequency induction electric field in the region including the surface of the substrate held by the target holder.

11. The thin-film formation sputtering device according to claim 10, wherein the substrate-activating radio-frequency antenna is arranged in a substrate-activating radio-frequency antenna placement section provided between the inner and outer surfaces of the wall of the vacuum container, and a second partition member made of a dielectric material is provided between the substrate-activating radio-frequency antenna and the inner space of the vacuum container.

12. The thin-film formation sputtering device according to one of claims 1 through 11, wherein:
the portion of the wall of the vacuum container in which the antenna placement section is provided is in a form of a projecting section protruding into the inner space of the vacuum container;
at least a portion of a lateral side of the projecting section, including a tip of the lateral side, is made of a dielectric material; and
the target holder is provided lateral to the projecting section.
